# EUROPEAN PATENT SPECIFICATION

(11) **EP 0 710 735 B1**
(45) Date of publication and mention of the grant of the patent: **30.12.1998**
(21) Application number: 95307869.8
(22) Date of filing: 03.11.1995
(51) Int. Cl.: C30B 13/00, C30B 29/22

(54) **Grain boundaryless manganese-based oxide crystalline body and method for the preparation thereof**
Korngrenzenloser Kristalliner Manganbasi-Oxidkörper und Verfahren zu seiner Herstellung
Corps cristallin sans joints de grains d'oxyde à base de manganèse et méthode pour sa préparation

(30) Priority: 04.11.1994 JP 271567/94
(43) Date of publication of application: 08.05.1996
(73) Proprietor: JAPAN as represented by DIRECTOR GENERAL OF AGENCY OF INDUSTRIAL SCIENCE AND TECHNOLOGY, Tokyo-to (JP); ANGSTROM TECHNOLOGY PARTNERSHIP, Tokyo-to (JP)
(72) Inventor: Asamitsu, Atsushi, c/o Nat. Inst. for Advanced, Tsukuba-shi, Ibaraki-ken (JP); Moritomo, Yutaka, c/o Nat. Inst. for Advanced, Tsukuba-shi, Ibaraki-ken (JP); Tokura, Yoshinori, c/o Nat. Inst. for Advanced, Tsukuba-shi, Ibaraki-ken (JP)
(74) Representative: Baverstock, Michael George Douglas

(56) References cited:
- JOURNAL OF CRYSTAL GROWTH, vol. 84, no. 2, August 1987 AMSTERDAM NL, pages 207-211, HASHIMOTO 'crystal growth and characterization of La1-xMxMnO3(M=Ca,Sr)'
- JOURNAL OF CRYSTAL GROWTH, vol. 60, no. 1, November 1982 AMSTERDAM NL, pages 191-194, TANAKA ET AL. 'crystal growth of (La0.8Ca0.2)Mn03 by the TSFZ method'

## Description

The present invention relates to a new manganese-based oxide material, of which phase changes in the crystalline structure can be controlled by means of a magnetic field at temperatures of 60 to 350 K, and which can implement resistance switching characteristics under a magnetic field by utilizing the phenomenon of hysteresis in the structural phase transition, and also relates to a manufacturing process thereof.

Recently, interest has been rekindled in the dynamics of spin-charge coupling, closely related to Mott transition in a 3d electron transition metal oxide having a strong electron correlation, as an extension of the studies of the properties under normal state of copper oxide superconductors. Among these materials, which are provided both with metallic properties and with strongly correlated 3d electrons, manganese oxide of the perovskite structure doped with holes, such as La₁₋ₓCaₓMnO₃ and La₁₋ₓSrₓMnO₃ are known to be ferromagnetic conductors. In these materials, ferromagnetism is mediated by the so-called double exchange interaction between Mn³⁺ and Mn⁴⁺ ions. With one of the manganese oxides belonging to this series, La_{0.09}Pb_{0.91}MnO₃, a large negative magnetoresistance has been observed around the magnetic phase transition temperature. More recently, it has been reported that thin films of La₁₋ₓCaₓMnO₃ and La₁₋ₓBaₓMnO₃ present negative magnetoresistance in a similar way (Appl. Phys. Let. 63:1990; Science 264:413 and Phys. Rev. Let. 71:2331). The single crystal growth of La₁₋ₓMₓ MnO₃ (M = Ca, Sr) where x is in the general range from 0 to 0.4 has also been reported (J. Crystal growth 84(2) pp 207-211).

The present invention has been made for the purpose of providing manganese oxide-based materials, of which phase changes in the crystalline structure can be controlled by magnetic fields at room temperature, and which can exhibit resistance switching characteristics under a magnetic field by use of hysteresis of structural phase transition.

The inventors of the present invention, who had been carrying out studies on manganese-based oxide materials of perovskite structure, discovered that grain boundaryless manganese oxide crystals of the perovskite structure with a ferromagnetic transition temperature (Tc) adjusted to be close to the structural phase transition temperature (Ts) caused a phase change under a magnetic field between rhombohedral and orthorhombic systems so as to exhibit a resistance switching memory effect, and that manganese oxide of perovskite structure with holes doped by replacing the lanthanum site with strontium could provide a single crystal with a ferromagnetic transition temperature close to the structural phase transition temperature, by adjusting precisely the atomic ratio of strontium to manganese. The present invention is based on these findings.

Specifically, the present invention provides as set out in claim 1 a grain boundaryless manganese oxide-based crystalline body of a perovskite structure having a composition expressed by the general formula:

La₁₋ₓSrₓMnO₃ (1)

where x has a value between 0.168 and 0.178, and a method as set out in claim 2 for the preparation thereof by mixing oxides of La, Sr and Mn or compounds of these elements which can be converted into respective oxides by heating in an atomic ratio corresponding to the composition in conformity with the above given general formula (1) , sintering the mixture in air and inducing crystal growth through the floating zone melting method. The invention also concerns the use of such a crystalline body as set out in claim 3.

In the drawings:

Figure 1 is a graph showing the temperature dependence of the resistivity of the crystals with "x" in the general formula (1) between 0.15 and 0.3.

Figure 2 is a graph showing the relationship between temperature and resistivity for a crystal according to the present invention for x=0.175 under different magnetic fields.

Figure 3 is a graph showing the relationship between magnetic field and resistivity for the same crystal as in Figure 2 at different temperatures.

Figure 4 is a graph showing phase changes in the crystalline structure for another crystal according to the present invention under varied magnetic fields.

Figure 5 is a graph showing the relationship between temperature and resistivity for the same crystal as shown in Figure 4 under different magnetic fields.

Figures 6a and 6b are each a graph showing the magnetostriction and resistivity, respectively, of a crystal according to the invention for x=0.170 as a function of magnetic field.

In the present invention, it is essential to adjust the value of "x" in the general formula (1) to fall between 0.168 and 0.178, otherwise it is impossible to obtain a single crystal of desired properties. In contrast to an ordinary sintered body of the perovskite structure, which is an aggregate of a great number of microcrystals subdivided by numerous grain boundaries, the crystal according to the present invention is characterized by a single-crystalline structure without grain boundaries. Owing to the specific composition and crystal growing process, it is possible to control the phase changes in the crystalline structure by means of a magnetic field at temperatures between 60 and 350 K, and to hold the resistivity switching characteristics by means of a magnetic field up to 100 kOe, by utilizing the phenomenon of hysteresis in the structural phase transition.

The grain boundaryless manganese-based oxide crystal can be prepared by using, for example, a powder mixture composed of La₂O₃, SrO and Mn₃O₄. As the starting materials, these oxides may be replaced with those compounds of the respective elements capable of being converted into the oxides by heating, such as carbonates La₂ (CO₃)₃, SrCO₃ and MnCO₃, or hydrogencarbonates La (HCO₃)₃, Sr (HCO₃)₂ and Mn(HCO₃)₂. These materials are weighed and mixed in such proportions that the La:Mn atomic ratio is 0.832 to 0.822 and the Sr:Mn atomic ratio is 0.168 to 0.178 with the proviso that the total of the atomic ratios (La/Mn)+(Sr/Mn) is equal to 1. It is advantageous to mix these starting materials in a wet process with admixture of a volatile organic solvent, such as an alcohol or ketone. The powder mixture is sintered in air at a temperature in the range from 1000 to 1100 °C, and the sintered lump is disintegrated into fine particles. The powder thus obtained is formed into a block, for example, having a cylindrical form by compression molding and further sintered at a temperature in the range from 1200 to 1300 °C. A crystal is grown by the conventional floating zone melting process. An appropriate travelling velocity of the molten zone is about 5 to 15 mm/hour. It necessary, a binder can be used in the shaping process of the powder.

For the crystalline body prepared in this way, the value of the subscript "x" in the general formula (1) can be determined by X-ray diffractometry, neutron diffraction analysis, electron-beam microprobe analysis and chemical analysis. In particular, it has been found that the value of "x" determined by electron-beam microprobe analysis has accuracy with an error of only ±0.01. Good coincidence could be obtained between the ferromagnetic transition temperature Tc in the inventive crystalline body as a function of "x" and the values heretofore reported for ceramic specimens.

The grain boundaryless crystal according to the present invention, in which "x" in the general formula (1) has a value between 0.168 and 0.178, exhibits magnetic transition including non-metal/metal transition due to magnetic-field induction, increases the wandering property of conduction electrons through magnetization under the application of a magnetic field, induces switching or primary phase transition in the crystalline lattice structure correlated thereto, and causes a reversible structural change between the rhombohedral and orthorhombic systems. Consequently, the resistivity changes are accompanied by a phenomenon of hysteresis as a function of the degree of the temperature-induced or magnetic field-induced magnetization. Accordingly, these changes can be utilized as a structural memory or a resistance-switching memory associated therewith.

In the following, the invention is described in further detail by way of examples.

### Example 1.

Powders of lanthanum oxide La₂O₃, strontium carbonate SrCO₃ and manganese oxide Mn₃O₄ as the starting materials were taken and mixed together in a weight proportion corresponding to the respective stoichiometric amount to give the value of "x" of 0.15, 0.175, 0.2 or 0.3 in the general formula (1). The powder mixture was thoroughly blended with addition of acetone in a ball mill for one hour. The powder mixture was calcined in air at 1200 °C for 24 hours and the sintered lump was disintegrated into a fine powder.

The powder prepared in this way was compression-molded in a hydraulic press under a pressure of 2 tons/cm² to form a cylindrical rod having a diameter of about 5 mm and a length of about 80 mm, which was subjected to sintering in air at 1200 °C for 12 hours.

By using a floating zone melting furnace equipped with two halogen sunlamps and semielliptic focusing mirrors, a crystal was grown at a growing velocity of 8 to 10 mm/hour with rotation of the seed crystal and the rod for crystal growing at a relative revolution of 30 rpm in reverse directions. The atmospheric gas was air when the value of "x" was 0.15, 0.175 or 0.2 and an oxygen-argon mixture when the value of "x" was 0.3.

In this way, four grain boundaryless manganese-based oxide crystalline bodies were obtained with different formulations corresponding to the respective values of "x".

### Reference Example 1.

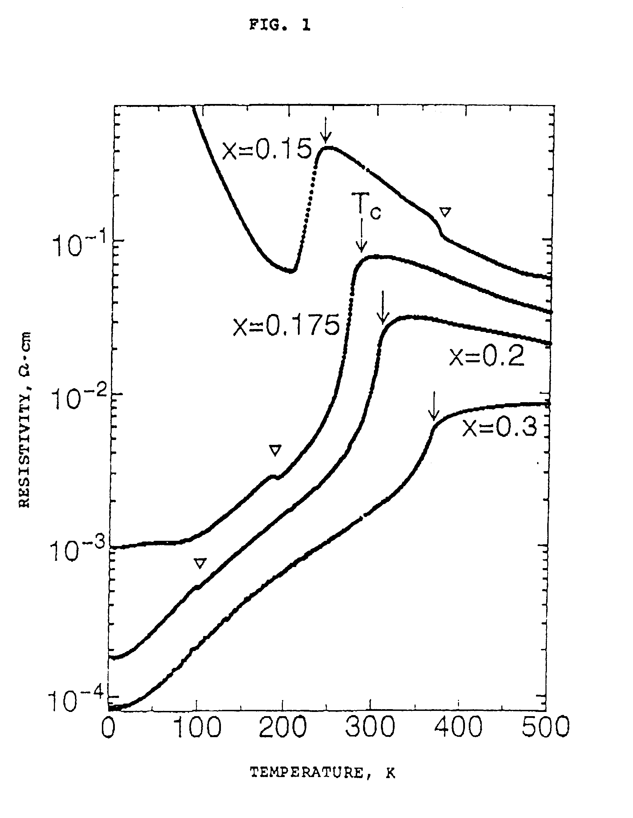

With the four grain boundaryless crystalline bodies obtained in Example 1, the temperature dependence of resistivity was examined in the vicinity of the respective non-metal/metal transition points to give the results shown in Fig. 1. As is evident in Fig. 1, a large drop was noted in resistivity just below the ferromagnetic transition temperature Tc indicated by the downwardly directed arrows. In the samples having a composition corresponding to the value of x in the range from 0.175 to 0.30, in particular, the resistivity in the low temperature region was smaller by almost two orders of magnitude than the value at the Tc. The shoulder points indicated by the mark ∇ on some of the curves in the figure can be attributed to a structural phase transition in the slightly distorted perovskite from the rhombohedral structure as the high-temperature phase to the orthorhombic structure as the low-temperature phase.

The well defined Tc thus appearing as well as the well defined structural phase transition temperature Ts indicate that the crystalline body is fairly homogeneous. Figure 1 shows that the Tc is very close to the Ts in the crystalline body corresponding to x=0.175.

### Reference Example 2.

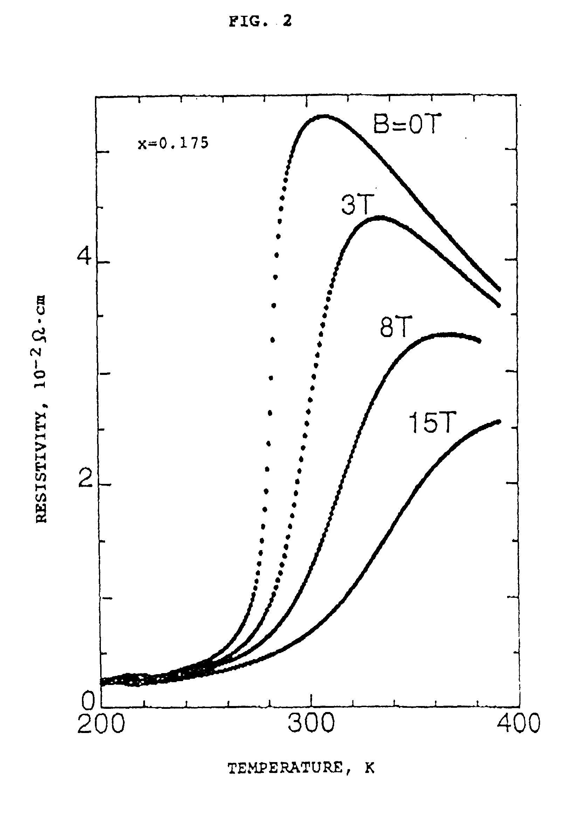

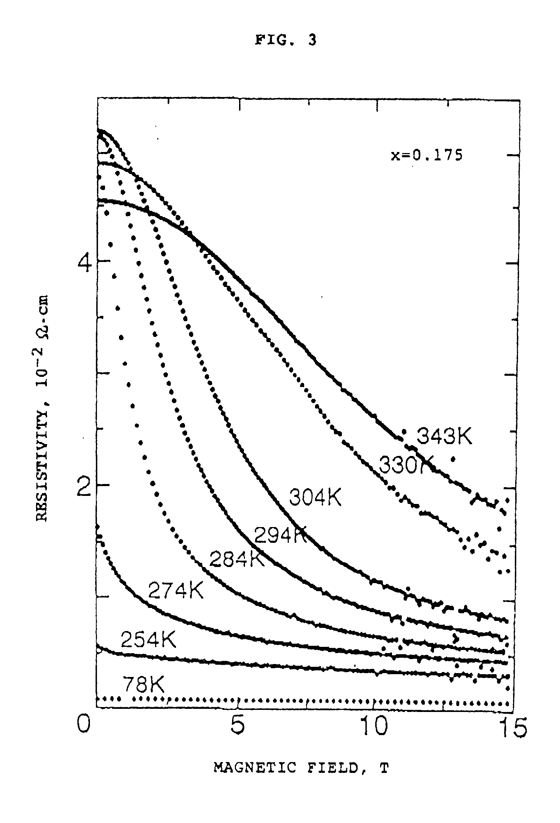

With the crystalline body closest to the non-metal/metal boundary corresponding to x=0.175, as obtained in Example 1, the effect of the magnetic field on resistivity was examined to give the results shown by the graphs in Figs. 2 and 3 for the relationship between temperature and resistivity and for the relationship between magnetic field and resistivity, respectively. In these Figures, anomalous very large negative magnetoresistance was found at around Tc. This magnetoresistance was found to be nearly isotropic. Specifically, the absolute value of the magnetoresistance in the transverse direction was only a few % smaller than the value in the longitudinal direction. In particular, the magnetoresistance defined by the formula [ρ (0)-ρ (B)]/ρ (0) was as high as 0.9 at around Tc, i.e. 283 K. Such a prominent phenomenon of magnetoresistance is presumably due to the magnetic field-induced non-metal/metal transition. By contrast, the effect of magnetoresistance at 77 K for the fully spin-ordered state was very small as compared with that at around Tc as is clearly seen in Fig. 3.

### Example 2.

In the same way as in Example 1, powders of lanthanum oxide La₂O₃, strontium carbonate SrCO₃ and manganese oxide Mn₃O₄ were mixed together to prepare a grain boundaryless crystalline body having a composition corresponding to the value x of 0.170 in the general formula (1).

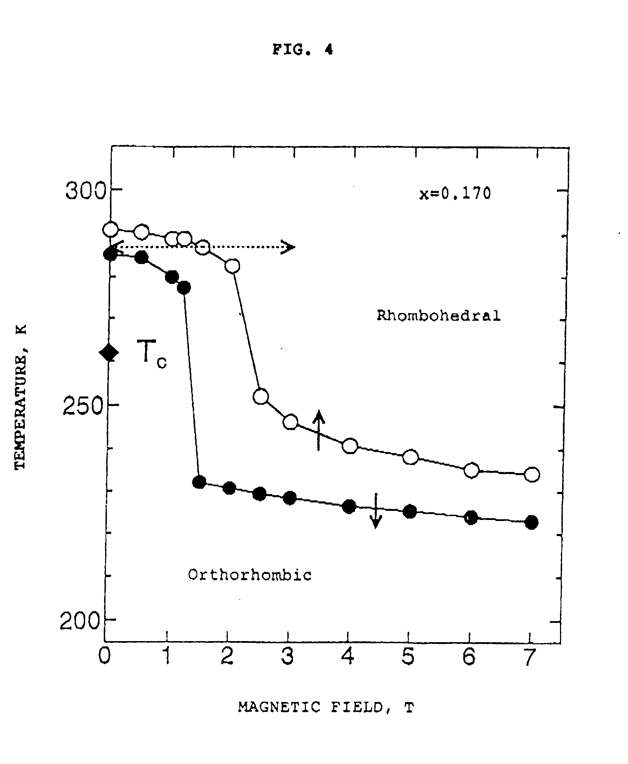

Phase changes in the crystalline structure induced by a magnetic field were examined with this crystalline body to give the results shown in Fig. 4. As is evident from this figure, the crystalline body was subject to a phase transition between orthorhombic and rhombohedral at around 287.0 K under application of a magnetic field.

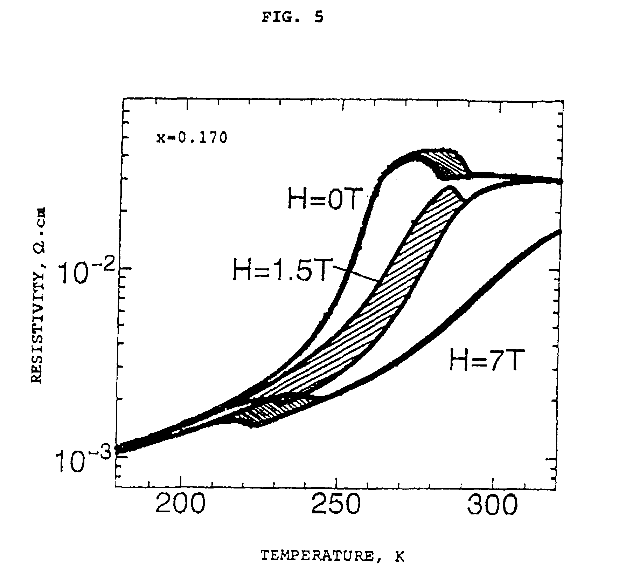

The relationship between temperature and resistivity was examined with this crystalline body in the absence of a magnetic field or under a magnetic field of 1.5T or 7T to give the results shown by the curves in Fig. 5, each of which indicates the phenomenon of hysteresis (shown by the hatched areas) suggesting that the crystalline body could be used as a switching means by the resistivity changes with magnetic fields.

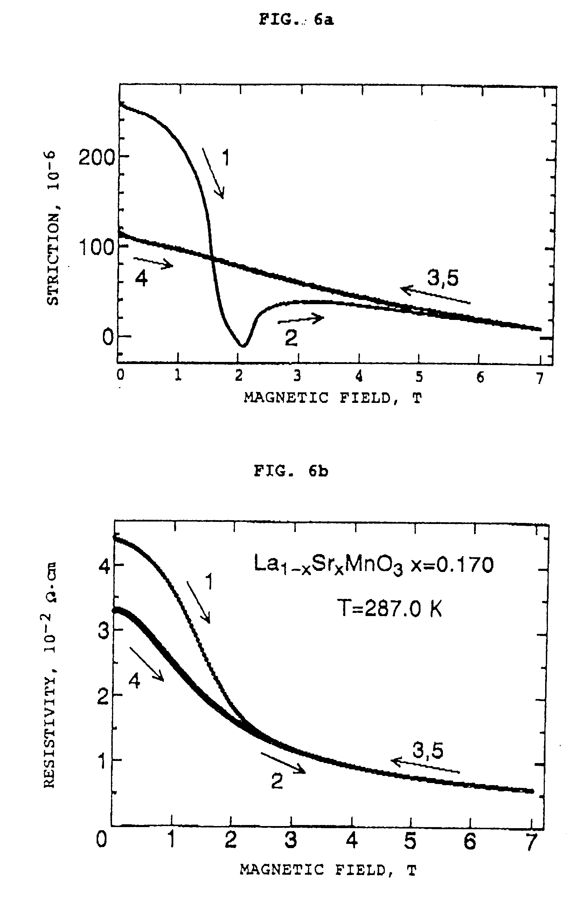

The above prepared crystalline body was subjected to measurement of magnetostriction and resistivity at 287.0 K as a function of magnetic field swept between 0 to 7T to give the results shown in Figs. 6a and 6b, respectively. Sweeping of the magnetic field was performed by increasing the field from zero field to 7T (arrows 1 and 2), decreasing the field from 7T back to zero field (arrow 3), increasing the field again up to 7T (arrow 4) and finally decreasing the field down to zero (arrow 5). As is understood from these Figures, reversibility was not held between the first run and the second run of the magnetic field sweeping.

## Claims

1. A grain boundaryless manganese-based oxide crystalline body of a perovskite structure having a chemical composition expressed by the general formula:
La₁₋ₓSrₓMnO₃,
in which the subscript x is a number in the range from 0.168 to 0.178.

2. A method for the preparation of a grain boundaryless manganese-based oxide crystalline body of a perovskite structure having a chemical composition expressed by the general formula:
La₁₋ₓSrₓMnO₃,
in which the subscript x is a number in the range from 0.168 to 0.178, which comprises the steps of:
(a) mixing oxides of lanthanum, strontium and manganese or compounds of lanthanum, strontium and manganese capable of being converted into oxides by heating in such a proportion as to satisfy the general formula
La₁₋ₓSrₓMnO₃,
in which the subscript x has the same meaning as defined above, to give a powder blend;
(b) sintering the powder blend in air into a sintered body; and
(c) subjecting the sintered body to crystal growth by the floating zone melting method.

3. Use of a grain boundaryless manganese-based oxide crystalline body of a perovskite structure as claimed in claim 1, or when prepared by a method as claimed in claim 2, in a memory switching-type magnetoresistance element.

## Patentansprüche

1. Korngrenzenloser, kristalliner Manganbasis-Oxidkörper mit einem Perovskitgefüge einer chemischen Zusammensetzung, die durch die allgemeine Formel:
La₁₋ₓSrₓMnO₃
ausgedrückt wird, in der der Index x eine Zahl im Bereich von 0,168 bis 0,178 ist.

2. Verfahren zur Herstellung eines korngrenzenlosen kristallinen Manganbasis-Oxidkörpers mit einem Perovskitgefüge einer chemischen Zusammensetzung, die durch die allgemeine Formel:
La₁₋ₓSrₓMnO₃
ausgedrückt wird, in der der Index x eine Zahl im Bereich von 0,168 bis 0,178 ist, das die Schritte aufweist:
a) Vermischen von Oxiden des Lanthans, Strontiums und Mangans oder Verbindungen des Lanthans, Strontiums und Mangans, die sich zur Umwandlung in Oxide durch Erhitzen eignen, in einem solchen Verhältnis, um der allgemeinen Formel
La₁₋ₓSrₓMnO₃
zu genügen, in der der Index x die gleiche Bedeutung, wie oben definiert, hat, zum Erhalten einer Pulvermischung;
b) Sintern der Pulvermischung in Luft zu einem gesinterten Körper; und
c) Unterwerfen des gesinterten Körpers einem Kristallwachstum durch das Schwimmzonenschmelzverfahren.

3. Verwendung eines korngrenzenlosen kristallinen Manganbasis-Oxidkörpers mit einem Perovskitgefüge, wie im Anspruch 1 beansprucht, oder nach Herstellung durch ein Verfahren, wie im Anspruch 2 beansprucht, in einem Speicherschalttyp-Magnetwiderstandsbauelement.

## Revendications

1. Corps cristallin d'oxyde à base de manganèse sans joints des grains d'une structure pérovskite ayant une composition chimique exprimée par la formule générale :
La₁₋ₓSrₓMnO₃,
dans laquelle l'indice x est un nombre compris entre 0,168 et 0,178.

2. Méthode pour la préparation d'un corps cristallin d'oxyde à base de manganèse sans joint des grains d'une structure pérovskite ayant une composition chimique exprimée par la formule générale :
La₁₋ₓSrₓMnO₃,
dans laquelle l'indice x est un nombre compris entre 0,168 et 0,178, qui comprend les étapes de :
(a) mélanger des oxydes de lanthane, strontium et manganèse ou des composés de lanthane, strontium et manganèse capables d'être convertis en oxydes par chauffage, à une proportion telle que cela satisfasse la formule générale
La₁₋ₓSrₓMnO₃,
dans laquelle l'indice x a la même signification que celle définie ci-dessus pour donner un mélange en poudre ;
(b) fritter le mélange en poudre à l'air en un corps fritté ; et
(c) soumettre le corps fritté à une croissance cristalline par la méthode de fusion en zone flottante.

3. Utilisation d'un corps cristallin d'oxyde à base de manganèse sans joints des grains d'une structure pérovskite selon la revendication 1, ou quand il est préparé par une méthode selon la revendication 2, dans un élément de magnétorésistance du type à changement de mémoire.
